# EUROPEAN PATENT SPECIFICATION

(11) **EP 1 798 561 B1**
(45) Date of publication and mention of the grant of the patent: **13.02.2008**
(21) Application number: 05027680.7
(22) Date of filing: 16.12.2005
(51) Int. Cl.: G01R 1/073, G01R 1/067, G01R 3/00

(54) **Treating method for repairing probes positioned on a test card**
Behandlungsverfahren um die auf einer Leitkarte positionierten Sonden zu reparieren
Procédé de traitement pour réparer les sondes positionnées sur une carte de test

(43) Date of publication of application: 20.06.2007
(73) Proprietor: Wang, Chih-Chung, Chiku Hsiang Tainan Hsien (TW); Lu, Wen-Yu, Jiali Township Tainan Hsien (TW)
(72) Inventor: Wang, Chih-Chung, Chiku Hsiang Tainan Hsien (TW); Lu, Wen-Yu, Jiali Township Tainan Hsien (TW)
(74) Representative: Volpert, Marcus

(56) References cited:
- US-A- 5 027 062
- US-A1- 2002 061 668
- US-A1- 2005 024 073
- PATENT ABSTRACTS OF JAPAN vol. 2002, no. 11, 6 November 2002 (2002-11-06) -& JP 2002 214295 A (MURATA MFG CO LTD), 31 July 2002 (2002-07-31)

## Description

### BACKGROUND OF THE INVENTION

### 1. Field of the Invention

This invention relates to a treating method for repairing probes positioned on a test card, particularly to one for plating a layer of film on the tips or the shanks of probes positioned on a test card, and the film material may be a metal, a metal alloy or a non-mental material depending on different necessities, so the probes may be repaired or not attract much dirt and residue, upgrading electric conductivity or insulating property, and preventing electromagnetic interference from occurring.

### 2. Description of the Prior Art

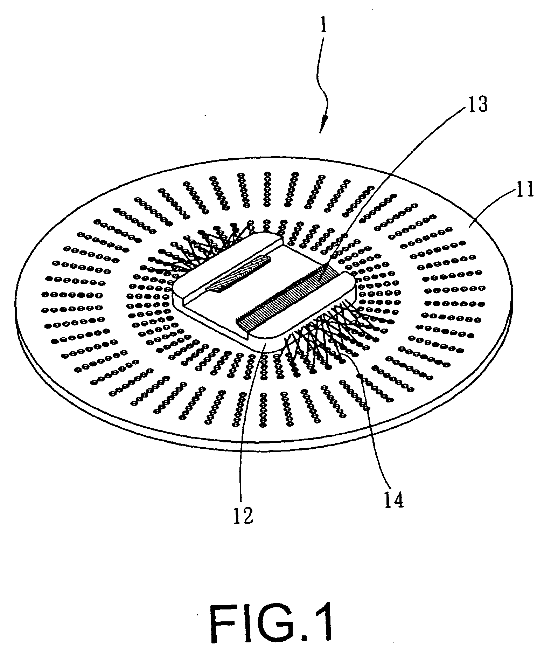

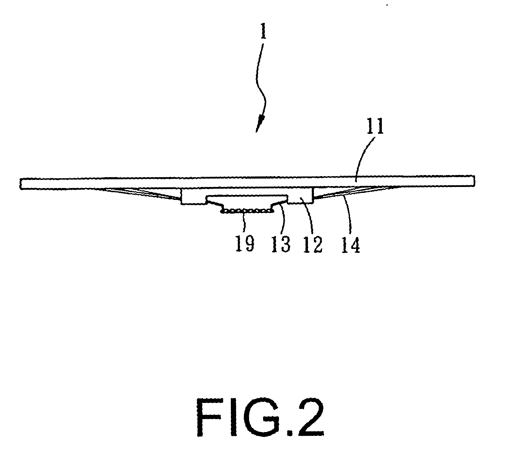

Common testees such as chip discs, IC, DRAM, etc. are to be tested by a tester to find whether they possess the designed capability features required or not. Then unqualified products may be eliminated to secure the quality of the products to be sold or used. A test card 1 used for testing is shown in Figs. 1 and 2, provided with a circuit board 11, a position base 12 mounted on the circuit board 11, and a plurality of probes 13 arranged on the position base 12. The probes 13 are connected electrically with the circuit board 11 by leads 14, made of conductive metal or other conductive materials and each having a fix end 131 fixed on the position base 12 and a contact end 132 bended and hanging over the circuit board 11. The contact end 132 contacts a signal point of a testee 19 to directly receive the input signal and a tested output so as to transmit electrical parameter measuring signals so that the testee 19 may be tested for its effectiveness.

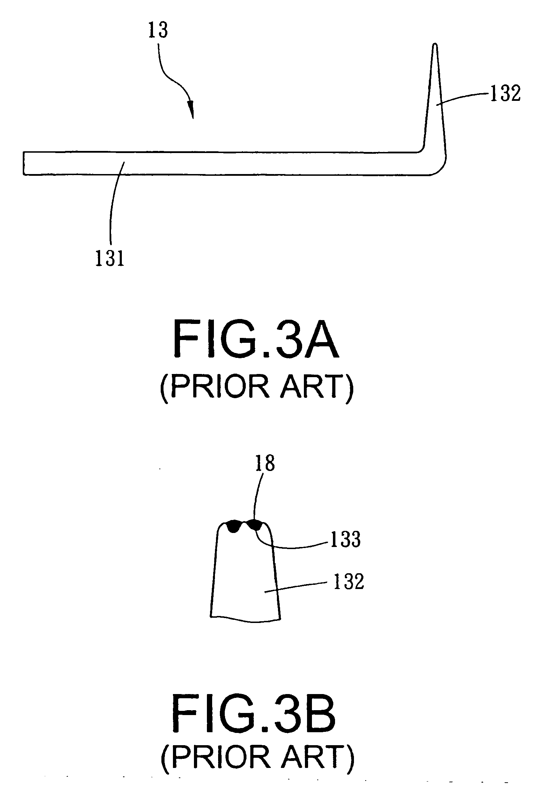

However, the probes 13 are made of conductive material, and spaced apart so closely that an electromagnetic interference may arise between two abutting probes 13, or an exterior thing may fall on a gap between two probes 13 to let the probes 13 malfunction. Generally speaking, the probes 13 may wear by frequent contacts with testees 19, and the wear may affect seriously dependability of the testing and the service life of the test card 1. The contact end 132 of each probe 13 has its surface 133 liable to be worn down and grown uneven, as shown in Fig. 3B, so dirt and residue 18 easily sticks to the surface 133, being hard to be cleaned, extremely affecting effectiveness of the testee 19, increasing retesting percentage. Therefore, dirt and residue 18 are to be first gotten rid of the surface 133 of the probe 13, with the surface 133 polished cleanly, or the probe 13 cannot be used. Besides, the probe 13 may shorten gradually after frequently being polished or ground and finally become too short to be used and to be discarded, resulting in a substantive loss.

From US-A-5,027,062 a method for manufacturing a probe test structure for microcircuits is known. Said method utilizes a multiple coating method in connection with a novel double-cell electroplating apparatus.

JP-A-2002 214 295 discloses a method for cleaning measuring probes is known according to which an electric arc between the tips of the measuring probes to be cleaned and a member for generating an arc is generated. The tips of the measuring probes are cleaned.

From US 2005/00 24 073 A1 a probe card is known having probe sections with silicon probes formed on an insulated circuit board that are connected by an adhesive on the supporting structures.

### SUMMARY OF THE INVENTION

The purpose of the invention is to offer a treating method for repairing probes positioned on a test card, increasing electrical conductivity, reducing wear and dirt and residue possible to stick on a tip and the surface of the shank of probes so the probes may be easily repaired and repeatedly used, having a long service life, and at same time boosting effectiveness of the probes.

The main feature of a treating method for repairing probes positioned on a test card in the invention includes the following steps:
(1). A first step is to cover a test card and portions of probes not to be repaired, only exposing surfaces of portions of the probes to be repaired.
(2). A second step is to place the test card and the probes in a plating device.
(3). A third step is to plate a conductive layer of film on the surfaces of the uncovered portions of the probes.

### BRIEF DESCRIPTION OF DRAWINGS

This invention will be better understood by referring to the accompanying drawings, wherein:
Figure 1 is a perspective view of a test card being used for testing in the present invention;
Figure 2 is a side view of the test card being used for testing in the present invention;
Figure 3A is a magnified view of a conventional probe in the present invention;
Figure 3B is a partial view of a conventional probe already worn down and stuck with dirt;
Figure 4 is a flowing chart of a first embodiment of a treating method for probes positioned on a test card in the present invention;
Figure 5A is a cross-sectional view of a probe in the present invention;
Figure 5B is a cross-sectional view of the probe plated with a layer of film in the present invention;
Figure 5C is a cross-sectional view of the probe covered with a layer of film worn down in the present invention;
Figure 5D is a cross-sectional view of the probe with a layer of film worn down and being repaired in the present invention;
Figure 5E is a cross-sectional view of the probe with a layer of film worn down, repaired and plated once again in the present invention;
Figure 6 is a flowing chart of a second embodiment of a treating method for probes positioned on a test card in the present invention;
Figure 7 is a flowing chart of a third embodiment of a treating method for probes positioned on a test card in the present invention; and,
Figure 8 is a cross-sectional view of a probe in the third embodiment of a treating method for probes positioned on a test card in the present invention, showing a tip of the probe plated with a layer of film and a shank of the probe plated with an insulating layer of film.

### DETAILED DESCRIPTION OF THE PREFERRED EMBODIMENT

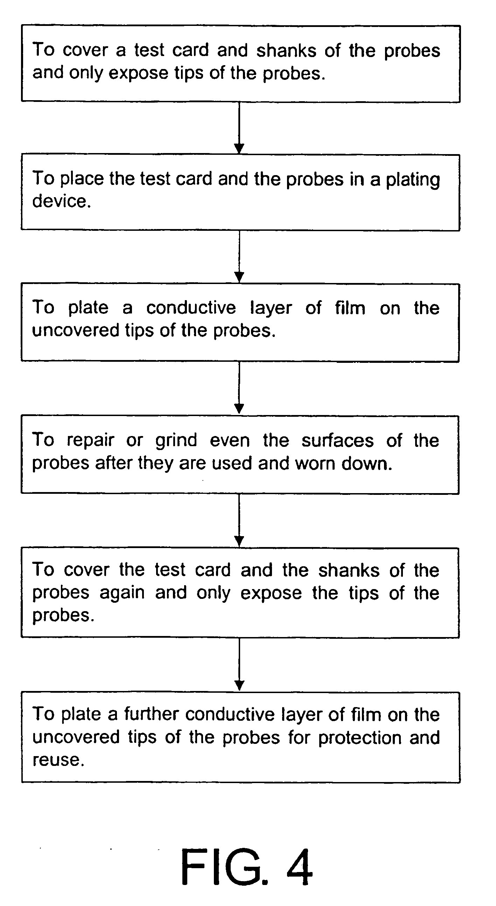

A first embodiment of a treating method for repairing probes positioned on a test card in the present invention, as shown in Fig. 4, includes six steps.

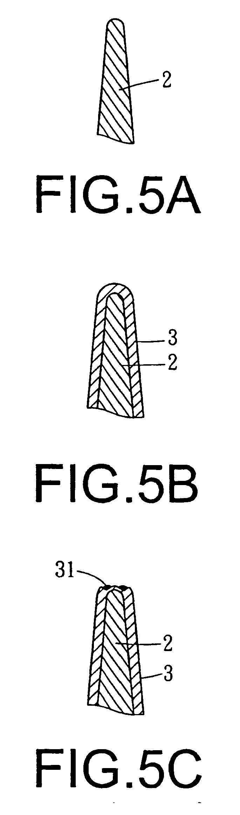

Probes 2 positioned on a test card are made of tungsten or tungsten alloy having rigidity and electric conductivity, as shown in Fig. 5A.

The first step is to cover the test card and the surfaces of shanks 22 of the probes 2, only exposing tips 21 of the probes 2.

The second step is to place the test card and the probes 2 in a plating device, and the plating device is vacuum plating cell.

The third step is to plate a conductive layer of film 3 on the surfaces of the uncovered tips 21 of the probes 2 for protection, as shown in Fig. 5B.

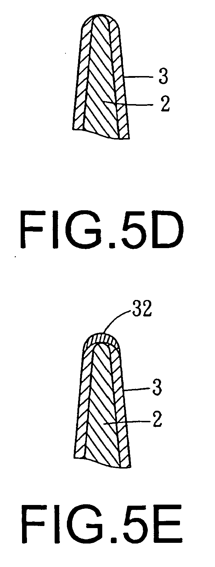

The fourth step is to repair or grind even the surfaces of the probes 2 being worn after the probes 2 are used, by removing the dirt and residue 31 on the surface of the film 3 and grinding or repairing, as shown in Figs. 5C and 5D.

The fifth step is to cover the test card and the shanks 22 of the probes 2 once again, only exposing the tips 21 of the probes 2.

The sixth step is to plate a further conductive layer of film 32 on the tips 21 of the probes 2, for protection and reuse, as shown in Fig. 5E.

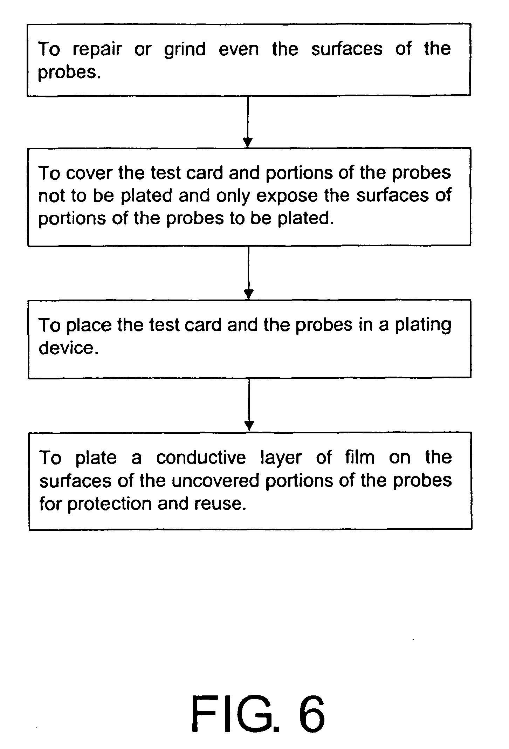

Next, a second embodiment of a treating method for repairing probes positioned on a test card in the present invention, as shown in Fig. 6, includes four steps, applied to the probes on the test card used and worn down, as shown in Fig. 5C.

The first step is to repair or grind even the surfaces of the probes 2; first clean dirt and residue 31 remained on the surface of the layer of film 3, and then grind or repair it smooth, as shown in Fig. 5D.

The second step is to cover the test card and portions of the probes 2 not to be repaired, only exposing the surfaces of portions of the probes 2 to be repaired.

The third step is to place the test card and the probes 2 in a plating device, and the plating device is a vacuum electric plating cell.

The fourth step is to plate a conductive layer of film 32 on the surfaces of the uncovered portions of the probes 2 for protection, as shown in Fig. 5E.

The materials of the layers of film 3 and 32 are not the same according to the objects or the using conditions, say, maybe metal, alloy, oxide, boron compound, fluoride, nitride, silicon compound, sulfide, tellurium compound, etc. The plating method can be electrical (electrolysis) such as a common electrical plating, compound electrical plating, alloy electrical plating, or non-electrical (non-electrolysis) such as physical vapor deposition including vacuum spattering, vacuum vapor deposition, or, chemical vapor deposition including atmosphere pressure chemical vapor deposition, low pressure chemical vapor deposition, plasma-enhanced chemical vapor deposition, etc.

As described above, the probes 2 with the layer of film 3 plated on their surfaces may not wear down so quickly, and only the layer of film 3 may be worn off, and further, if the layer of film 3 is worn off, it can be repaired or ground even and plated once again with a further layer of film 32 for reuse. If the layer of film 32 is worn off, it can be again repaired and plated for reuse, and so on. So the service life of the probes may be prolonged a great deal, reducing their cost.

Moreover, common conventional probes will wear down by frequent contact, and the bad wear may affect dependability and the service life of the test card, but using the treating method according to the invention probes may be repeatedly used, prolonged in the service life for a great extent. In addition, in spite of frequent contact with testees (objects to be tested), the probes 2 according to the invention have conductive and friction-enduring layers of film 3 and 32 on their surfaces, thus making the surfaces of the probes 2 smooth to reduce the amount of material of testees possibly sticking to the probes 2. And the stuck material may be easily removed so the testing effectiveness may be boosted a great deal. Further, the probes 2 positioned on a test card are not needed to be taken down even for proceeding plating a layer of film by covering the portions not to be repaired, but exposing the portions to be repaired, and then putting the test card and the probes 2 in the plating device, convenient for treating for plating again and again.

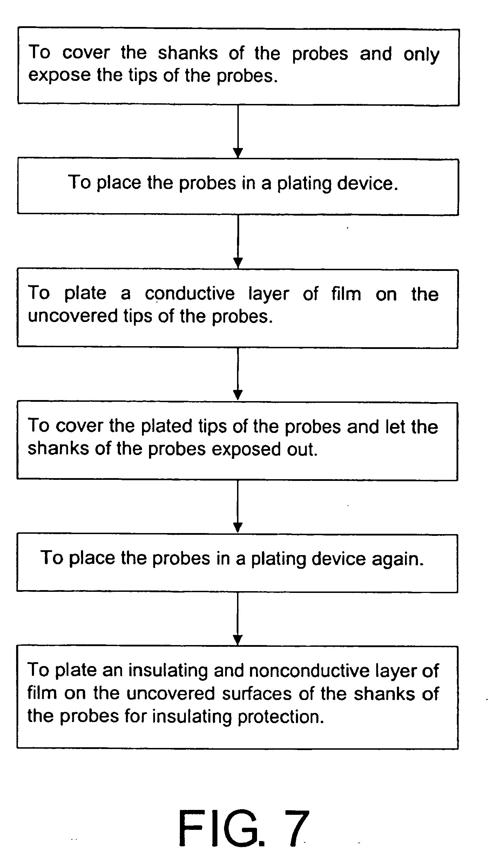

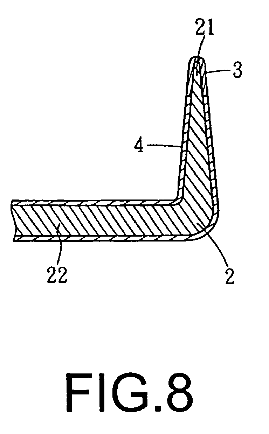

Next, a third embodiment of a treating method for repairing probes positioned on a test card in the present invention, as shown in Figs. 7 and 8, is designed for preventing electric interference between the probes 2 and short circuit caused by exterior matters falling on the probes 2, including six steps to be described below.

The first step is to cover the shanks 22 of the probes 2, only exposing the tips 21 of the probes 2.

The second step is to place the probes 2 in a plating cell, and the plating device is a vacuum plating cell.

The third step is to plate a conductive layer of film 3 on the uncovered tips 21 of the probes 2.

The fourth step is to cover the plated tips 21 of the probes 2 and let the shanks 22 of the probes 22 exposed out.

The fifth step is to place the probes 2 in a plating device again.

The sixth step is to plate an insulating and nonconductive layer of film 4 on the uncovered surfaces of the shanks 22 of the probes 2 for insulating protection.

Therefore, the tips 21 of the probes 2 have a conductive layer of film 3 conductive to electricity, and the shanks 22 of the probes 2 have an insulating and nonconductive layer of film 4 as shown in Fig. 8. So the probes 2 are not susceptible to electric interference owning to the insulating and nonconductive layer of film 4, and is protected from causing short circuit also owing to the insulating and nonconductive layer of film 4 even if an exterior matter should fall on the probes 2. Therefore, the probes 2 may function normally, upgrading effectiveness of testing and lessening retesting necessity.

The invention has the following advantages, as can be understood from the foresaid description.
1. The probes have anti-wear property owing to a layer of film functioning as a protective means for reducing wear and tear.
2. The surface treatment of the probes can increase electric conductivity and reduce possibility of sticking of residue or dirt on the surface of the probes, with stuck residue or dirt easily removable.
3. The layer of film plated on the surfaces of the probes is possible to be repaired and plated once again for reuse, largely cutting possibility of wearing-down of the probes, prolonging its service life.
4. The probes positioned on a test card can be plated without taken off the test card, not needing covering the portions not to be repaired, but only exposing the portions to be repaired in a plating device for plating, facilitating plating process repeatedly.

While the preferred embodiments of the invention have been described above, it will be recognized and understood that various modifications may be made without departing from the scope of the invention as defined by the appended claims.

## Claims

1. Treating method for repairing probes (2) positioned on a test card (1), said treating method comprising:
(1) a first step of covering a test card (1) and portions of probes (2) not to be repaired, only exposing the tips (21) of said probes (2) to be repaired;
(2) a second step of placing said test card (1) and said probes(2) in a plating device; and
(3) a third step of plating a conductive layer of film (3) on said surfaces of said uncovered tips (21) of said probes (2).

2. Treating method according to claim 1, **characterized by** repairing or grinding even the surfaces of the probes (2) being worn after the probes (2) are used, by removing the dirt and residue (31) on the surface of the film (3); and repeating steps (1) to (3) in order to plate a further conductive layer of film (32) on said tips (21) of the probes (2).

3. Treating method according to claim 1 or 2, further **characterized by** covering a test card (1) and portions of probes (2) not to be repaired, only exposing the shanks (22) of said probes (2) to be repaired; placing said test card (1) and said probes (2) in a plating device; and plating an insulating layer of film (4) on said surfaces of said uncovered shanks (22) of said probes (2).

## Patentansprüche

1. Behandlungsverfahren zur Reparatur von Sonden (2), die auf einer Testkarte (1) angeordnet sind, umfassend:
(1) einen ersten Schritt zur Abdeckung der Testkarte (1) und nicht zu reparierende Teile der Sonden (2), wobei nur die Spitzen (21) der zu reparierenden Sonden (2) freiliegen;
(2) einen zweiten Schritt der Anordnung der Testkarte (1) und der Sonden (2) in einer Beschichtungseinrichtung; und
(3) einen dritten Schritt der Aufbringung einer Leiterschicht des Films (3) auf den Oberflächen der nicht abgedeckten Spitzen (21) der Sonden (2).

2. Behandlungsverfahren nach Anspruch 1, **gekennzeichnet durch** Reparieren oder Schleifen zum Glätten der Oberflächen der Sonden (2), die verschlissen sind, nachdem die Sonden benutzt worden sind, wodurch der Schmutz und die Restbestandteile (31) auf der Oberfläche des Films (3) entfernt werden, und **durch** Wiederholen der Schritte (1) bis (3), um eine weitere leitfähige Schicht des Films (32) auf den Spitzen (21) der Sonden (2) aufzubringen.

3. Behandlungsverfahren nach Anspruch 1 und 2, ferner **gekennzeichnet durch** Abdecken einer Testkarte (1) und von Teilen der Sonden (2), die nicht repariert werden sollen, Freilegen nur derjenigen Schäfte (22) der Sonden (2), die repariert werden sollen, Ablegen der Testkarte (1) und der Sonden (2) in einer Beschichtungseinrichtung und Beschichten der Oberflächen der nicht abgedeckten Schäfte (22) der Sonden (2) mit einer isolierenden Filmschicht (4).

## Revendications

1. Procédé de traitement pour réparer des sondes (2) positionnées sur une carte de test (1), ledit procédé de traitement comprenant :
(1) une première étape consistant à couvrir une carte de test (1) et des portions des sondes (2) qui ne sont pas à réparer, en exposant uniquement les embouts (21) desdites sondes (2) qui sont à réparer ;
(2) une seconde étape consistant à placer ladite carte de test (1) et lesdites sondes (2) dans un dispositif de placage ; et
(3) une troisième étape consistant à plaquer une couche conductrice d'un film (3) sur lesdites surfaces desdits embouts non couverts (21) desdites sondes (2).

2. Procédé de traitement selon la revendication 1, **caractérisé en ce qu'**on répare ou qu'on meule à plat les surfaces des sondes (2) qui sont usées après avoir utilisé les sondes (2), **en ce qu'**on enlève les saletés et les résidus (31) sur la surface du film (3) ; et **en ce qu'**on répète les étapes (1) à (3) afin de plaquer une autre couche conductrice de film (32) sur lesdits embouts (21) des sondes (2).

3. Procédé de traitement selon la revendication 1 ou 2, **caractérisé en outre en ce qu'**on couvre une carte de test (1) et des portions des sondes (2) qui ne sont pas à réparer, en exposant uniquement les corps (22) desdites sondes (2) qui sont à réparer, **en ce qu'**on place ladite carte de test (1) et lesdites sondes (2) dans un dispositif de placage ; et **en ce qu'**on plaque une couche isolante de film (4) sur lesdites surfaces desdits corps (22) non couverts desdites sondes (2).
